# EUROPEAN PATENT SPECIFICATION

(11) **EP 4 258 337 B1**
(45) Date of publication and mention of the grant of the patent: **24.12.2025**
(21) Application number: 21900266.4
(22) Date of filing: 01.09.2021
(51) Int. Cl.: H01L 23/373, H01L 23/367, H01L 25/07, H01L 25/18, H02M 1/32, H02M 7/00, H01L 23/538, H01L 23/051, H01L 23/31, H01L 25/16, H01L 23/48

(54) **INSULATED BOARD AND POWER CONVERTER**
ISOLIERTE LEITERPLATTE UND STROMWANDLER
CARTE ISOLÉE ET CONVERTISSEUR DE PUISSANCE

(30) Priority: 03.12.2020 JP 2020200810
(43) Date of publication of application: 11.10.2023
(73) Proprietor: Hitachi, Ltd., Tokyo 100-8280 (JP)
(72) Inventor: MATSUSHIMA, Hiroyuki, Tokyo 100-8280 (JP); MORI, Yuki, Tokyo 100-8280 (JP); SHIMA, Akio, Tokyo 100-8280 (JP)
(74) Representative: MERH-IP Matias Erny Reichl Hoffmann Patentanwälte PartG mbB
(86) International application number: PCT/JP2021/032188
(87) International publication number: WO 2022/118510

(56) References cited:
- WO-A1-2014/175062
- WO-A1-2015/049944
- FR-A1- 3 084 960
- JP-A- 2013 008 940
- JP-A- 2015 185 630
- JP-A- 2019 046 899
- US-A1- 2016 027 711
- US-A1- 2017 154 877

## Description

### Technical Field

The present invention relates to an insulating substrate and a power conversion apparatus, and more particularly to an insulating substrate for mounting a semiconductor chip and a power conversion apparatus using the insulating substrate.

### Background Art

In recent years, a power semiconductor chip of SiC, GaN, or the like, using a compound semiconductor substrate having a wideband gap, has been developed, and a power conversion apparatus having the power semiconductor chip mounted thereon has started to be introduced into the market. Since the power semiconductor chip of SiC, GaN, or the like has a smaller conduction loss than that of a related-art Si power semiconductor chip, a cooling system of the power conversion apparatus can be simplified.

Since the power semiconductor chip of SiC, GaN, or the like can be driven at a high frequency, passive components such as inductors or capacitors provided in the power conversion apparatus can be downsized. With these effects, it is possible to reduce an overall size of the power conversion apparatus.

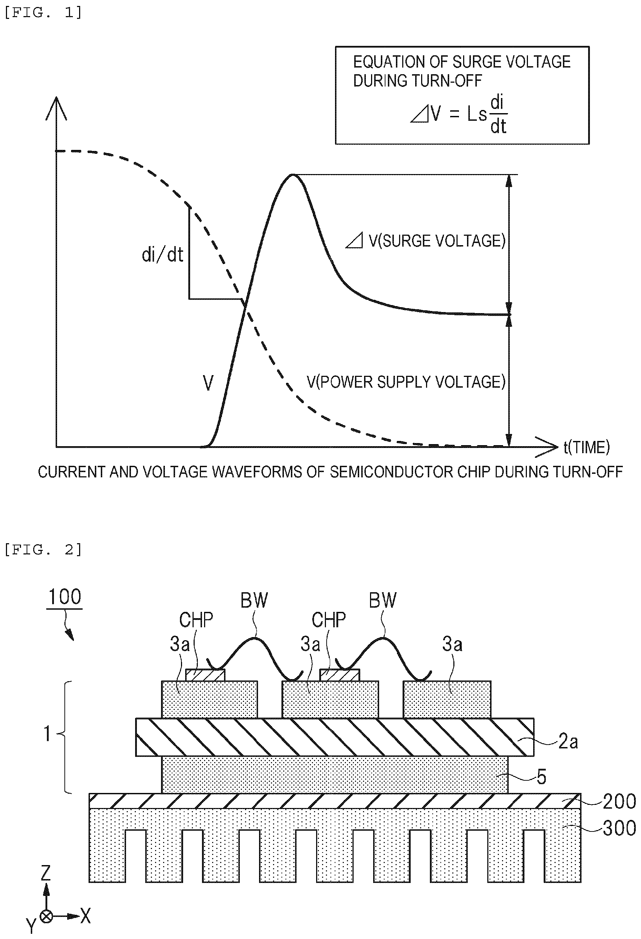

A parasitic inductance Ls of the power conversion apparatus becomes a problem during high-frequency driving. As shown in FIG. 1, a surge voltage ΔV is represented by a product of the parasitic inductance Ls and an amount of current per time unit (di/dt). The large parasitic inductance Ls causes the large surge voltage ΔV to be applied when the semiconductor chip is turned off, and also becomes a source of noise. For high-frequency driving, it is necessary to increase an off-speed of the semiconductor chip, but the surge voltage ΔV and the noise greatly affect the off-speed.

For example, PTL 1 discloses an insulating substrate including an insulating plate, a top surface wiring conductor formed on a top surface of the insulating plate, and a back surface wiring conductor formed on a back surface of the insulating plate. A semiconductor chip is disposed on the top surface wiring conductor. Here, PTL 1 discloses a technique for reducing a parasitic inductance using a bridge terminal provided on the top surface wiring conductor due to an effect of proximity reverse conduction. PTL 2 describes a power conversion apparatus with an insulating substrate having selective contacts between its electrically conductive layers. PTL 3 describes a power conversion apparatus with an insulating substrate and double-sided cooling. PTL 4 further describes another power conversion apparatus with insulating substrate and transistors on compound semiconductor substrates.

### Citation List

### Patent Literature

PTL 1: JP2015-185630A
PTL 2:FR 3 084 960 A1
PTL3:WO 2015/049944 A1
PTL4:US 2017/154877 A1

### Summary of Invention

### Technical Problem

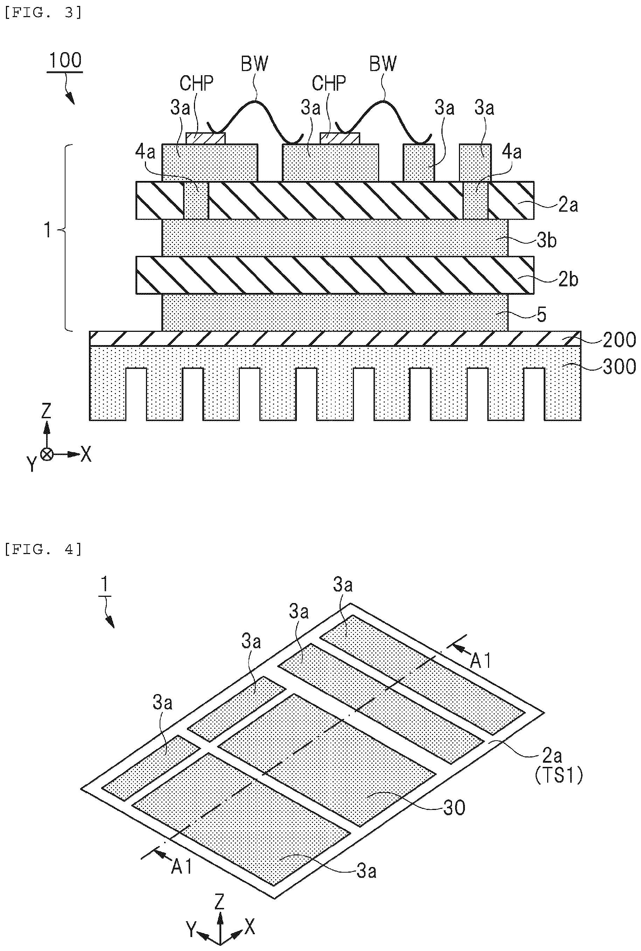

The inventors of the present application have studied structures according to Study Example 1 shown in FIG. 2 and Study Example 2 shown in FIG. 3 as power conversion apparatus 100 for compound semiconductor substrates.

As shown in FIG. 2, the power conversion apparatus 100 according to Study Example 1 uses an insulating substrate 1 including an insulating plate 2a, a plurality of conductors 3a formed on a top surface of the insulating plate 2a, and a heat dissipation conductor 5 formed on a back surface of the insulating plate 2a.

A plurality of semiconductor chips CHP are disposed on the plurality of conductors 3a, and the plurality of conductors 3a and the plurality of semiconductor chips CHP are electrically connected by bonding wires BW as appropriate. The heat dissipation conductor 5 is connected to a heat sink 300 via a base plate 200.

As shown in FIG. 3, the power conversion apparatus 100 according to Study Example 2 further includes a conductor 3b and an insulating plate 2b between the insulating plate 2a and the heat dissipation conductor 5, thereby forming a multilayer insulating substrate structure. For this reason, in Study Example 2, since insulating plates and conductors through which a current flows are stacked for a plurality of layers, the parasitic inductance Ls can be reduced by mutual inductance as compared with Study Example 1.

However, in Study Example 2, since a distance from the semiconductor chips CHP as heat sources to a cooling system (heat sink 300) increases due to formation of the multilayer insulating substrate structure, a temperature of each of the semiconductor chips CHP tends to rise due to an increase in thermal resistance as compared with Study Example 1. As a result, a temperature difference between the maximum temperature and the minimum temperature increases, which makes the conductor 3a to be likely to peel off from the semiconductor chip CHP. Similarly, peeling is likely to occur between the heat dissipation conductor 5 and the base plate 200 and between the base plate 200 and the heat sink 300. Not only the temperature of the semiconductor chip CHP but also a temperature of the entire power conversion apparatus 100 tends to rise, and thus reliability of the power conversion apparatus 100 may be lowered and a product life may be shortened.

Therefore, it is desirable to develop the insulating substrate 1 capable of keeping the parasitic inductance Ls low and improving heat dissipation, thereby improving reliability of the power conversion apparatus 100. Other problems and novel features will be apparent from the description of the present specification and the accompanying drawings.

### Solution to Problem

Overviews of representative aspects in embodiments disclosed in the present application will be briefly described as follows.

According to one aspect, there is provided an insulating substrate including: a first insulating plate including a top surface and a back surface; a second insulating plate formed on a back surface side of the first insulating plate and including a top surface and a back surface; a plurality of first conductors formed on the top surface of the first insulating plate; a second conductor formed between the back surface of the first insulating plate and the top surface of the second insulating plate; a heat dissipation conductor formed on the back surface of the second insulating plate and electrically insulated from the second conductor; and a plurality of first connection conductors formed inside the first insulating plate in a manner of electrically connecting some of the plurality of first conductors and the second conductor. Here, the plurality of first conductors include a first non-connected conductor that is not electrically connected to the second conductor via the plurality of first connection conductors, a protruding conductor is formed in the first insulating plate in a manner of being embedded in the first insulating plate and protruding from the back surface of the first insulating plate, and the protruding conductor is electrically connected to the first non-connected conductor, and is electrically insulated from the second conductor and the heat dissipation conductor.

According to another aspect, there is provided an insulating substrate including: a first insulating plate including a top surface and a back surface; a plurality of first conductors formed on the top surface of the first insulating plate; a plurality of second conductors formed on the back surface of the first insulating plate; and a plurality of first connection conductors formed inside the first insulating plate in a manner of electrically connecting some of the plurality of first conductors and some of the plurality of second conductors. Here, the plurality of second conductors include a second non-connected conductor electrically insulated from another second conductor, and a heat dissipation conductor is connected to the second non-connected conductor in a manner of protruding from the other second conductor on a back surface side of the first insulating plate.

### Advantageous Effects of Invention

According to the aspects, it is possible to provide an insulating substrate capable of keeping a parasitic inductance low and improving heat dissipation. Reliability of a power conversion apparatus can be improved using such an insulating substrate.

### Brief Description of Drawings

[FIG. 1] FIG. 1 is a graph showing a surge voltage during turn-off.
[FIG. 2] FIG. 2 is a cross-sectional view showing an insulating substrate and a power conversion apparatus according to Study Example 1.
[FIG. 3] FIG. 3 is a cross-sectional view showing an insulating substrate and a power conversion apparatus according to Study Example 2.
[FIG. 4] FIG. 4 is a perspective view showing an insulating substrate according to Embodiment 1.
[FIG. 5] FIG. 5 is a cross-sectional view showing the insulating substrate according to Embodiment 1.
[FIG. 6] FIG. 6 is a plan view showing the inside of the insulating substrate according to Embodiment 1.
[FIG. 7] FIG. 7 is a plan view showing the inside of the insulating substrate according to Embodiment 1.
[FIG. 8] FIG. 8 is a perspective view showing a power conversion apparatus according to Embodiment 1.
[FIG. 9] FIG. 9 is a cross-sectional view showing the power conversion apparatus according to Embodiment 1.
[FIG. 10] FIG. 10 is a cross-sectional view showing the power conversion apparatus according to Embodiment 1.
[FIG. 11] FIG. 11 is a graph showing effects according to Embodiment 1 and Embodiment 3.
[FIG. 12] FIG. 12 is a graph showing effects according to Embodiment 1 and Embodiment 3.
[FIG. 13] FIG. 13 is a cross-sectional view showing an insulating substrate according to Embodiment 2.
[FIG. 14] FIG. 14 is a cross-sectional view showing a power conversion apparatus according to Embodiment 2.
[FIG. 15] FIG. 15 is a plan view showing the inside of an insulating substrate according to Embodiment 3.
[FIG. 16] FIG. 16 is a cross-sectional view showing the insulating substrate according to Embodiment 3.
[FIG. 17] FIG. 17 is a cross-sectional view showing the insulating substrate according to Embodiment 3.
[FIG. 18] FIG. 18 is a cross-sectional view showing a power conversion apparatus according to Embodiment 3.
[FIG. 19] FIG. 19 is a plan view showing the inside of an insulating substrate according to Embodiment 4.
[FIG. 20] FIG. 20 is a cross-sectional view showing the insulating substrate according to Embodiment 4.
[FIG. 21] FIG. 21 is a cross-sectional view showing the insulating substrate according to Embodiment 4.
[FIG. 22] FIG. 22 is a cross-sectional view showing a power conversion apparatus according to Embodiment 4.
[FIG. 23] FIG. 23 is a cross-sectional view showing a power conversion apparatus according to a modification.
[FIG. 24] FIG. 24 is a cross-sectional view showing the power conversion apparatus according to the modification.

### Description of Embodiments

Hereinafter, embodiments of the invention will be described in detail with reference to the drawings. In all the drawings showing the embodiments, members having the same functions are denoted by the same reference numerals, and the repeated description thereof will be omitted. In the following embodiments, the description of the same or similar parts will not be repeated in principle unless particularly necessary.

An X direction, a Y direction, and a Z direction described in the present application intersect with one another and are orthogonal to one another. In the present application, the Z direction is referred to as a vertical direction, an upper-lower direction, a height direction, or a thickness direction of a certain structure. An expression "plan view" used in the present application means viewing a plane formed by the X direction and the Y direction from the Z direction.

### (Embodiment 1)

### <Configuration of Insulating Substrate 1>

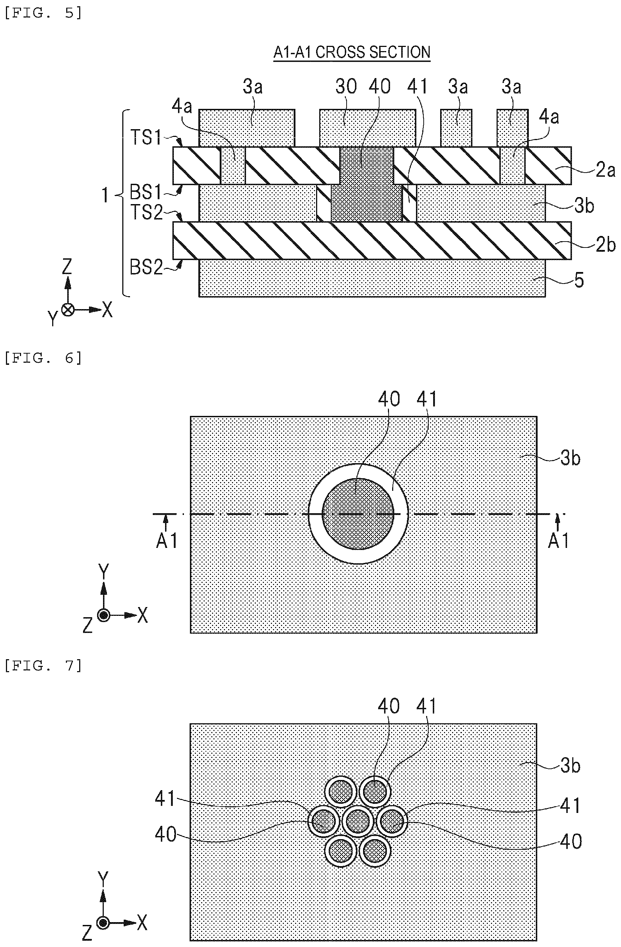

Hereinafter, an insulating substrate 1 according to Embodiment 1 will be described with reference to FIGS. 4 to 7. FIG. 4 is a perspective view showing the insulating substrate 1, and FIG. 5 is a cross-sectional view taken along a line A1-A1 shown in FIG. 4. FIGS. 6 and 7 are plan views showing a layer of the insulating substrate 1, a conductor 3b.

The insulating substrate 1 includes a multilayer insulating substrate structure in which insulating plates and conductors through which a current flows are stacked for a plurality of layers. The insulating substrate 1 includes an insulating plate 2a, an insulating plate 2b, a plurality of conductors 3a, the conductor 3b, a plurality of connection conductors 4a, and a heat dissipation conductor 5.

The insulating plate 2a includes a top surface TS1 and a back surface BS1. As shown in FIG. 4, the plurality of conductors 3a are formed on the top surface TS1 of the insulating plate 2a. The plurality of conductors 3a include a non-connected conductor 30.

As shown in FIG. 5, the insulating plate 2b is formed on a back surface BS1 side of the insulating plate 2a and has a top surface TS2 and a back surface BS2. The conductor 3b is formed between the back surface BS1 of the insulating plate 2a and the top surface TS2 of the insulating plate 2b. The plurality of connection conductors 4a are formed in the insulating plate 2a in a manner of electrically connecting some of the plurality of conductors 3a and the conductor 3b. The heat dissipation conductor 5 electrically insulated from the conductor 3b is formed on the back surface BS2 of the insulating plate 2b.

As will be described later, various electronic devices such as a plurality of semiconductor chips, capacitors, and inductors are disposed on the plurality of conductors 3a, and electrical conduction among the electronic devices is formed and a current path is constructed by electrically connecting the plurality of conductors 3a, the plurality of connection conductors 4a, and the conductor 3b. A case where one conductor 3b is provided is illustrated here. Alternatively, a plurality of conductors 3b may be provided. In this case, a more complicated circuit can be constructed by the plurality of conductors 3b.

In the insulating substrate 1 according to Embodiment 1, since the current path is multi-layered, a parasitic inductance Ls can be reduced by mutual inductance.

As described above, when a plurality of semiconductor chips are disposed on the plurality of conductors 3a, the insulating substrate 1 has a multilayer insulating substrate structure. Therefore, a distance between the plurality of semiconductor chips and the heat dissipation conductor 5 may increase, and heat dissipation may tend to deteriorate.

Here, the plurality of conductors 3a include the non-connected conductor 30 that is not electrically connected to the conductor 3b via the plurality of connection conductors 4a. Since a heat dissipation path electrically insulated from the current path is provided below the non-connected conductor 30, heat dissipation can be improved.

As shown in FIG. 5, a protruding conductor 40 is formed in the insulating plate 2a in a manner of being embedded in the insulating plate 2a and protruding from the back surface BS1 of the insulating plate 2a. The protruding conductor 40 is electrically connected to the non-connected conductor 30, and is electrically insulated from the heat dissipation conductor 5 by the insulating plate 2b.

As shown in FIGS. 5 and 6, the protruding conductor 40 is electrically insulated from the conductor 3b by an insulating layer 41 surrounding the protruding conductor 40 in a plan view. By using such a protruding conductor 40 as a heat dissipation path independent of an electric path formed by the conductor 3b or the like, the parasitic inductance Ls can be kept low, and heat dissipation can be improved.

A plurality of protruding conductors 40 may be provided as shown in FIG. 7 instead of only one as shown in FIG 6. In FIG. 7, the plurality of protruding conductors 40 are formed in the insulating plate 2a. Each of the plurality of protruding conductors 40 is electrically connected to the non-connected conductor 30, electrically insulated from the conductor 3b by the insulating layer 41, and electrically insulated from the heat dissipation conductor 5 by the insulating plate 2b.

In a case in FIG. 7, a planar area of each protruding conductor 40 is smaller than that in FIG. 6, but heat dissipation can be ensured substantially the same in FIG. 7 as that in FIG. 6 when a total planar area of the plurality of protruding conductors 40 is designed to be substantially the same as that in FIG. 6.

The plurality of conductors 3a including the non-connected conductor 30, the conductor 3b, the heat dissipation conductor 5, the plurality of connection conductors 4a, and the protruding conductor 40 are made of, for example, a metal material containing copper (Cu) or aluminum (Al). The insulating plate 2a and the insulating plate 2b are made of, for example, a ceramic or resin material.

### <Configuration of Power Conversion Apparatus 100>

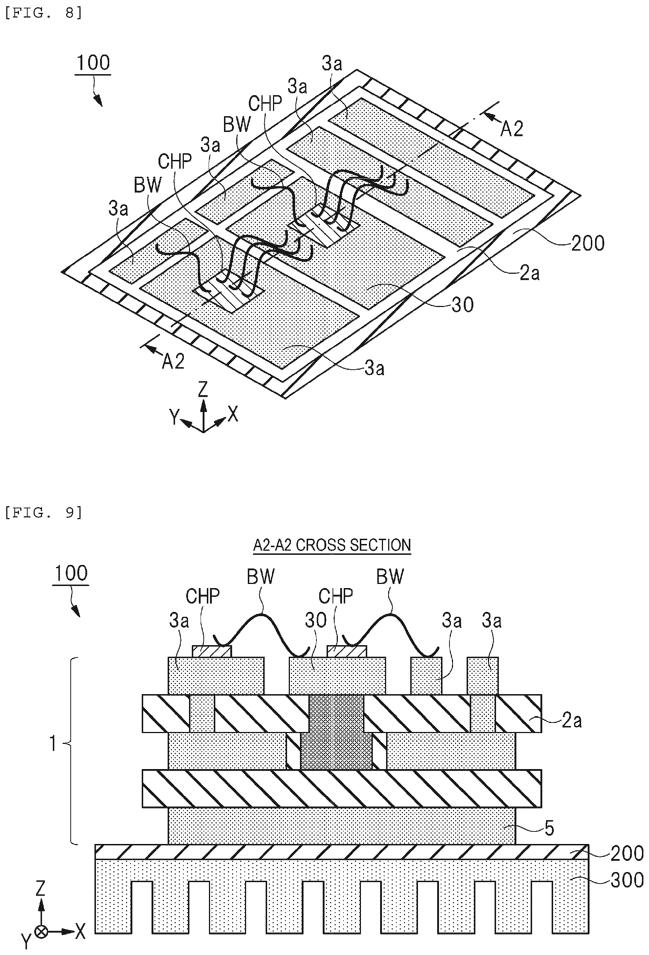

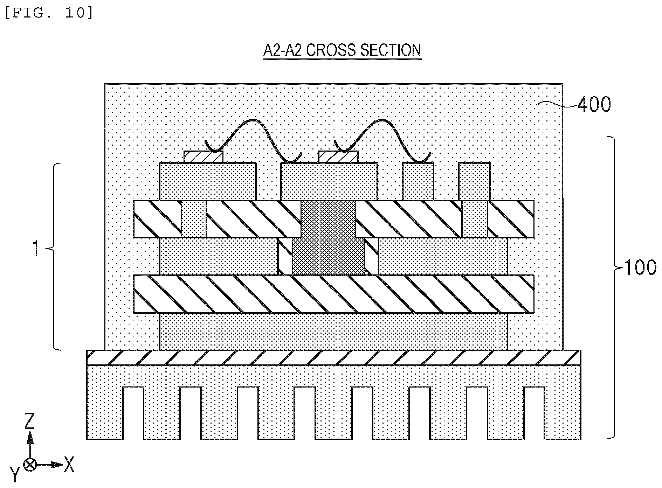

Hereinafter, a power conversion apparatus 100 according to Embodiment 1 will be described with reference to FIGS. 8 to 10. FIG. 8 is a perspective view showing the power conversion apparatus 100, and FIGS. 9 and 10 are cross-sectional views taken along a line A2-A2 shown in FIG 8. The line A2-A2 is located on the same straight line as the line A1-A1 shown in FIGS. 4 and 6.

The power conversion apparatus 100 includes the insulating substrate 1, a plurality of semiconductor chips CHP, bonding wires BW, a base plate 200 and a heat sink 300.

As shown in FIGS. 8 and 9, the heat sink 300 is connected to the heat dissipation conductor 5 via the base plate 200. Here, the heat dissipation conductor 5 and the base plate 200 are connected to each other via a thermal interface material (TIM). The base plate 200 and the heat sink 300 are also connected via a TIM. The TIM is, for example, a material such as solder or a sintered material. Each of the plurality of semiconductor chips CHP has a top surface and a back surface, and back surfaces of the plurality of semiconductor chips CHP are disposed on the plurality of conductors 3a by a TIM. At least one of the plurality of semiconductor chips CHP is provided on the non-connected conductor 30. The plurality of semiconductor chips CHP and the plurality of conductors 3a are electrically connected to each other by the bonding wires BW as appropriate.

Although not particularly shown, in addition to the plurality of semiconductor chips CHP, other electronic devices such as capacitors and inductors may be disposed on the plurality of conductors 3a.

As shown in FIG. 10, in the power conversion apparatus 100, the insulating substrate 1, the plurality of semiconductor chips CHP, and the bonding wires BW may be covered with a protective member 400. This can prevent the insulating substrate 1, the semiconductor chips CHP, and the bonding wires BW from discharging with an external environment. The protective member 400 is made of an insulating material, and is made of, for example, an insulating gel or a molding resin.

The semiconductor chip CHP includes, for example, a compound semiconductor substrate of silicon carbide (SiC), gallium nitride (GaN), gallium oxide (Ga₂O₃), or the like, and a transistor such as a MOSFET formed on the compound semiconductor substrate.

The bonding wire BW is made of, for example, a metal material containing gold (Au), copper (Cu), or aluminum (Al). The plurality of semiconductor chips CHP and the plurality of conductors 3a may be electrically connected by ribbons, bus bars, or the like instead of the bonding wires BW.

The base plate 200 is made of, for example, a composite material (AlSiC) in which SiC ceramic particles are contained in copper (Cu) or an aluminum alloy, or a composite material (MgSiC) in which SiC ceramic particles are contained in magnesium. The heat sink 300 is made of, for example, a metal material containing copper (Cu), iron (Fe), or aluminum.

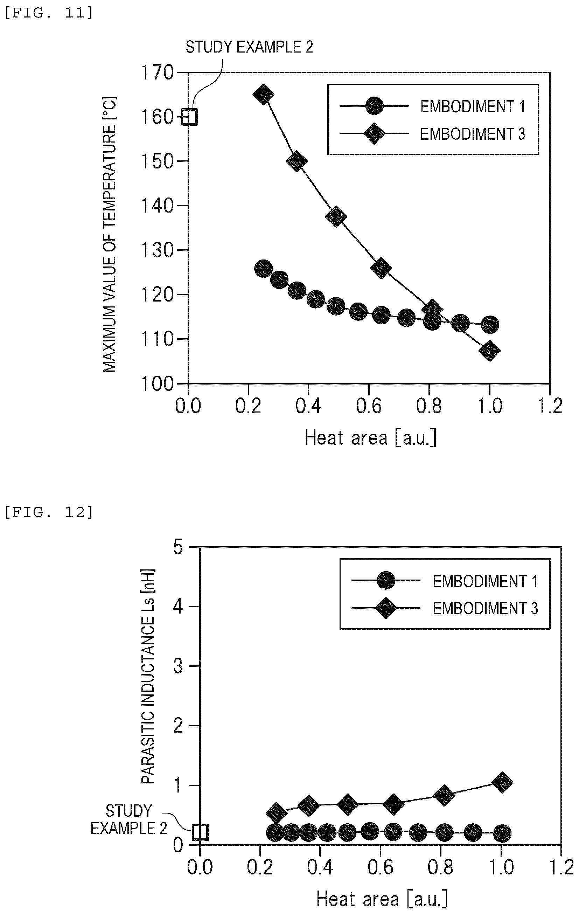

FIGS. 11 and 12 are graphs showing effects according to Embodiment 1, and are simulation results measured by the inventors of the present application. FIGS. 11 and 12 also show effects according to Embodiment 3 described later. In Embodiment 1, "Heat area" on a horizontal axis in FIGS. 11 and 12 indicates an area of the protruding conductor 40 in a plan view.

As shown in FIGS. 11 and 12, in the power conversion apparatus 100 according to Embodiment 1, a temperature rise can be prevented as compared with Study Example 2 (FIG. 3), and the parasitic inductance Ls can be maintained to be substantially the same as that in Study Example 2 (FIG. 3). That is, according to Embodiment 1, it is possible to provide the insulating substrate 1 capable of keeping the parasitic inductance Ls low and improving heat dissipation, and reliability of the power conversion apparatus 100 can be improved using such an insulating substrate 1.

### (Embodiment 2)

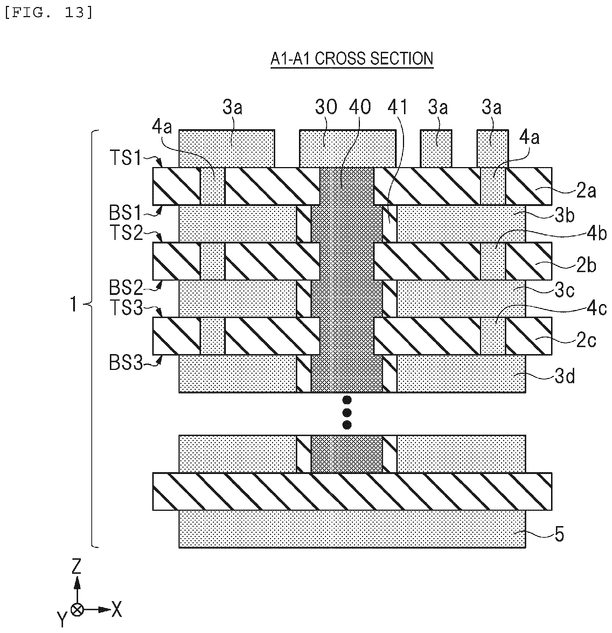

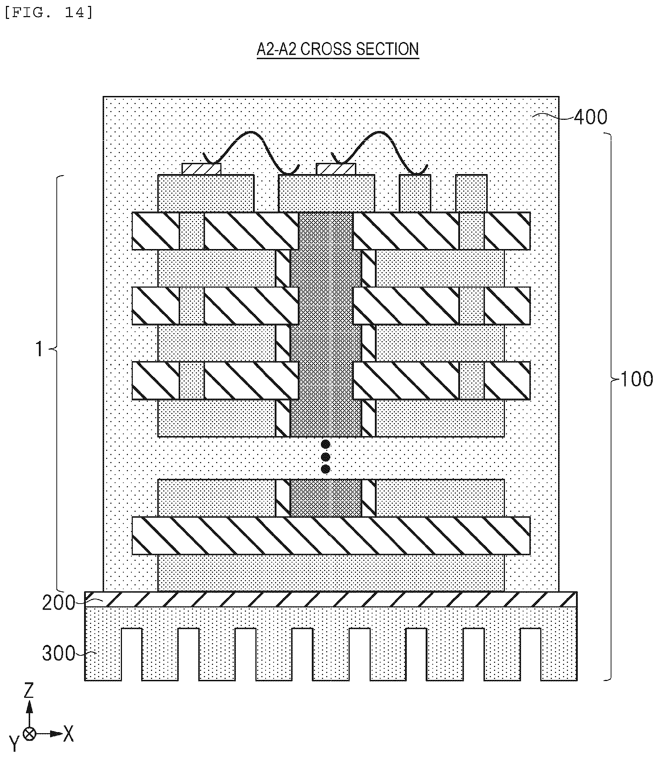

Hereinafter, the insulating substrate 1 and the power conversion apparatus 100 according to Embodiment 2 will be described with reference to FIGS. 13 and 14. In the following description, differences from Embodiment 1 will be mainly described, and the description of points overlapping with Embodiment 1 will be omitted.

As compared with Embodiment 1, the insulating substrate 1 according to Embodiment 2 has a multilayer insulating substrate structure in which more insulating plates and conductors are stacked between the insulating plate 2b and the heat dissipation conductor 5.

As shown in FIG. 13, an insulating plate 2c including a top surface TS3 and a back surface BS3 is formed between the insulating plate 2b and the heat dissipation conductor 5. A conductor 3c is formed between the back surface BS2 of the insulating plate 2b and the top surface TS3 of the insulating plate 2c. A plurality of connection conductors 4b are formed in the insulating plate 2b in a manner of electrically connecting the conductor 3b and the conductor 3c. The protruding conductor 40 penetrates the insulating plate 2b, protrudes from the back surface of the insulating plate 2b, and is electrically insulated from the conductor 3c and the connection conductors 4b.

As described above, in Embodiment 2, a structure including the insulating plate 2c, the conductor 3c, the plurality of connection conductors 4b, and the protruding conductor 40 is repeatedly formed once or more from the insulating plate 2b to the heat dissipation conductor 5. For example, when the structure is repeatedly formed twice, a conductor 3d, connection conductors 4c, and the like shown in FIG. 13 are formed.

FIG. 14 shows the power conversion apparatus 100 using the insulating substrate 1 according to Embodiment 2. In Embodiment 2, the insulating substrate 1 that is further multi-layered, a plurality of semiconductor chips CHP, and the bonding wires BW may also be covered with the protective member 400.

Various electronic devices such as the plurality of semiconductor chips CHP, capacitors, and inductors are disposed on a plurality of conductors 3a, but the insulating substrate 1 is further multi-layered. Therefore, it is easier to freely design connection paths of these electronic devices, and a degree of freedom in circuit design can be increased. It is also easier to freely design a current path that reduces the parasitic inductor Ls.

Even when the insulating substrate 1 is further multi-layered as described above, since the protruding conductor 40 penetrates the insulating plates, a heat dissipation path can be ensured. Therefore, deterioration in heat dissipation can be prevented. Therefore, reliability of the power conversion apparatus 100 using the insulating substrate 1 can be improved.

### (Embodiment 3)

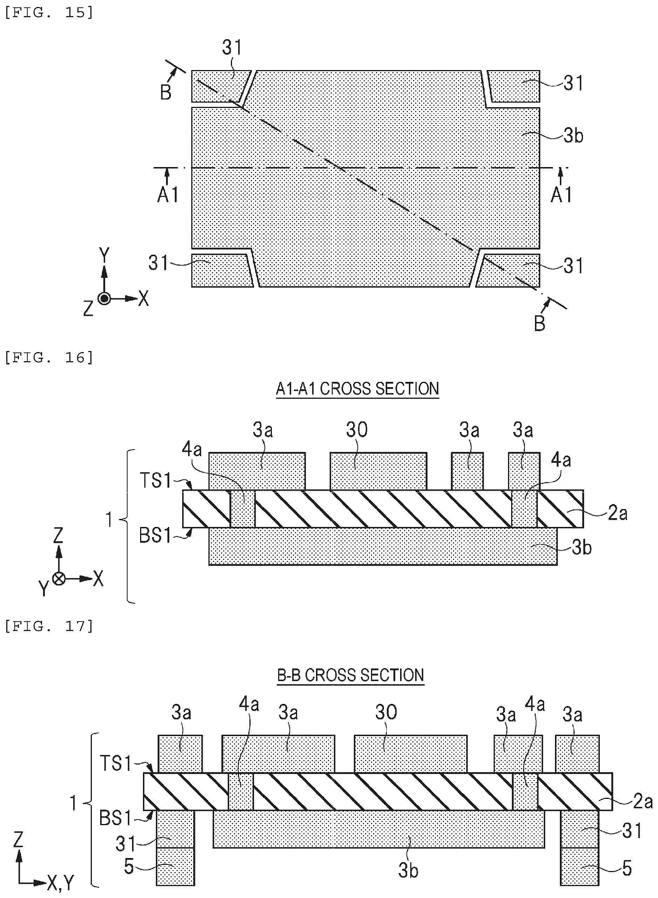

Hereinafter, the insulating substrate 1 and the power conversion apparatus 100 according to Embodiment 3 will be described with reference to FIGS. 15 to 18. In the following description, differences from Embodiment 1 will be mainly described, and the description of points overlapping with Embodiment 1 will be omitted.

In Embodiment 1, when the insulating substrate 1 has the multilayer insulating substrate structure, heat dissipation is improved by connecting the protruding conductor 40 to the non-connected conductor 30. In Embodiment 3, when the insulating substrate 1 has a single-layer insulating substrate structure, heat dissipation is improved by other devices.

FIG. 15 is a plan view showing a layer of the insulating substrate 1, the conductors 3b, according to Embodiment 3. FIG. 16 is a cross-sectional view taken along the line A1-A1 shown in FIG. 15, and FIG. 17 is a cross-sectional view taken along a line B-B shown in FIG. 15.

As shown in FIG. 16, a plurality of conductors 3a, the non-connected conductor 30, the insulating plate 2a, and the connection conductors 4a according to Embodiment 3 are the same as in Embodiment 1. However, in Embodiment 3, the insulating plate 2b is not formed, and the protruding conductor 40 for connection to the non-connected conductor 30 is also not formed.

As shown in FIGS. 15 and 17, in Embodiment 3, a plurality of conductors 3b are formed, and the plurality of conductors 3b include non-connected conductors 31 electrically insulated from another conductor 3b. The non-connected conductors 31 are electrically insulated from the other conductor 3b and the connection conductors 4a. Here, the non-connected conductors 31 are provided at four corners of the insulating substrate 1, but the number and positions of the non-connected conductors 31 can be changed as appropriate.

The heat dissipation conductor 5 is connected to each of the plurality of non-connected conductors 31 in a manner of protruding from the other conductor 3b on a back surface BS1 side of the insulating plate 2a. That is, the heat dissipation conductor 5 is not connected to the conductor 3b other than the non-connected conductors 31. In other words, a total thickness of the non-connected conductor 31 and the heat dissipation conductor 5 is larger than a thickness of the conductor 3b other than the non-connected conductors 31.

As described above, in Embodiment 3, the conductor 3b other than the non-connected conductors 31 serves as a current path, and the non-connected conductor 31 and the heat dissipation conductor 5 constitute a heat dissipation path insulated from the current path.

Since the non-connected conductors 31 are electrically insulated from the plurality of conductors 3a, the plurality of conductors 3a can be freely arranged above the non-connected conductors 31. By increasing an arrangement area of the plurality of conductors 3a, heat dissipation from a top surface TS1 side of the insulating plate 2a can be improved. When some of the plurality of conductors 3a are not provided in the current path, the connection conductors 4a may be provided at lower portions of some of the conductors 3a, and some of the conductors 3a and the non-connected conductors 31 may be connected to each other via the connection conductors 4a. Such a method can also improve heat dissipation.

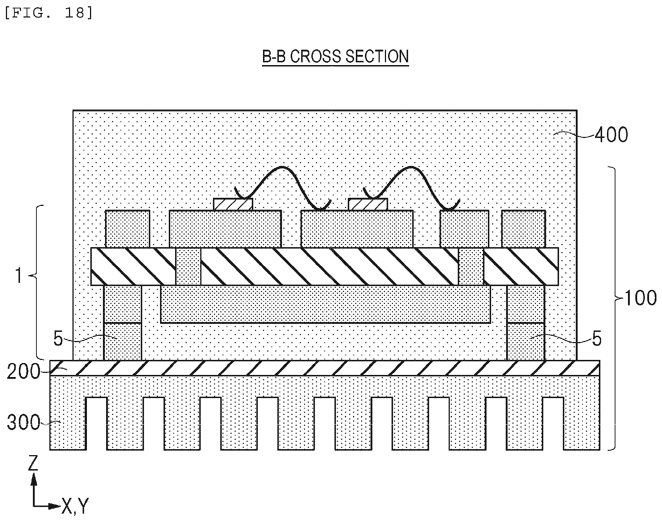

FIG. 18 shows the power conversion apparatus 100 using the insulating substrate 1 according to Embodiment 3. The heat dissipation conductors 5 are connected to the heat sink 300 via the base plate 200. In Embodiment 3, the insulating substrate 1, a plurality of semiconductor chips CHP, and the bonding wires BW are also covered with the protective member 400.

Here, since the protective member 400 is present between the conductor 3b serving as the current path and the non-connected conductors 31 and between the conductor 3b serving as the current path and the base plate 200, these members are electrically insulated.

FIGS. 11 and 12 show the effects according to Embodiment 3. In Embodiment 3, "Heat area" on the horizontal axis in FIGS. 11 and 12 indicates an area of the heat dissipation conductors 5 in a plan view (here, a total area of the four heat dissipation conductors 5).

As shown in FIGS. 11 and 12, in the power conversion apparatus 100 according to Embodiment 3, a temperature rise can be prevented as compared with Study Example 2 (FIG. 3). Meanwhile, since the insulating substrate 1 according to Embodiment 3 basically has the single-layer insulating substrate structure, the parasitic inductance Ls is higher in Embodiment 3 than in Study Example 2 (FIG. 3), but the parasitic inductance Ls is substantially the same in Embodiment 3 as that in Study Example 1 (FIG. 1), which has a single-layer insulating substrate structure.

That is, Embodiment 3 can also provide the insulating substrate 1 capable of keeping the parasitic inductance Ls low and improving heat dissipation, and reliability of the power conversion apparatus 100 can be improved using such an insulating substrate 1.

### (Embodiment 4)

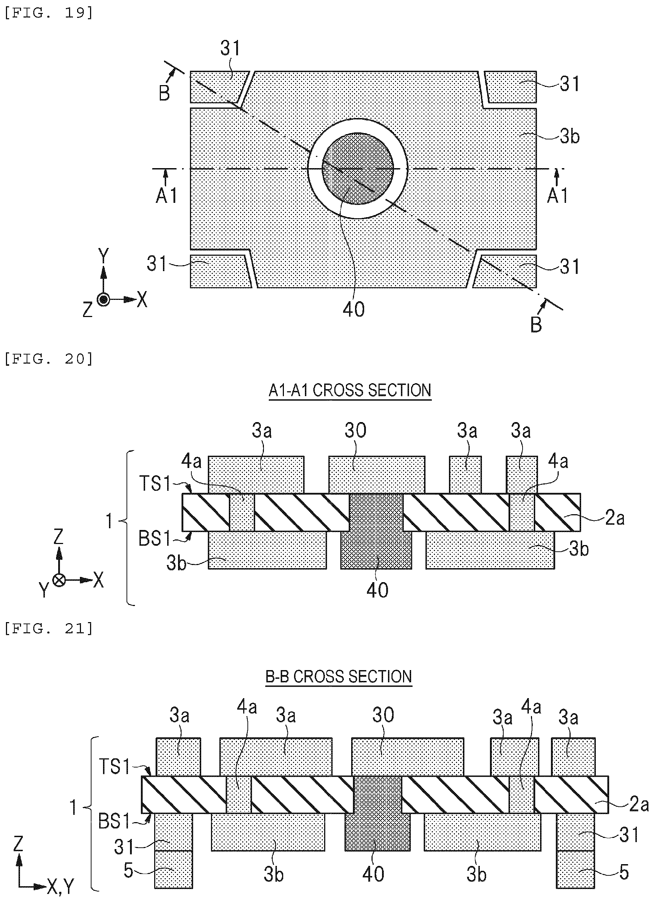

Hereinafter, the insulating substrate 1 and the power conversion apparatus 100 according to Embodiment 4 will be described with reference to FIGS. 19 to 22. In the following description, differences from Embodiment 3 will be mainly described, and the description of points overlapping with Embodiment 3 will be omitted.

In Embodiment 4, the protruding conductor 40 described in Embodiment 1 is applied based on the insulating substrate 1 according to Embodiment 3.

FIG. 19 is a plan view showing a layer of the insulating substrate 1, the conductors 3b, according to Embodiment 4. FIG. 20 is a cross-sectional view taken along the line A1-A1 shown in FIG. 19, and FIG. 21 is a cross-sectional view taken along the line B-B shown in FIG. 19.

As shown in FIGS. 19 to 21, the protruding conductor 40 is formed in the insulating plate 2a in a manner of being embedded in the insulating plate 2a and protruding from the back surface BS1 of the insulating plate 2a. The protruding conductor 40 is electrically connected to the non-connected conductor 30, and is electrically insulated from the conductor 3b, the non-connected conductors 31, and the heat dissipation conductors 5. A plurality of protruding conductors 40 as shown in FIG. 7 can be also applied in Embodiment 4.

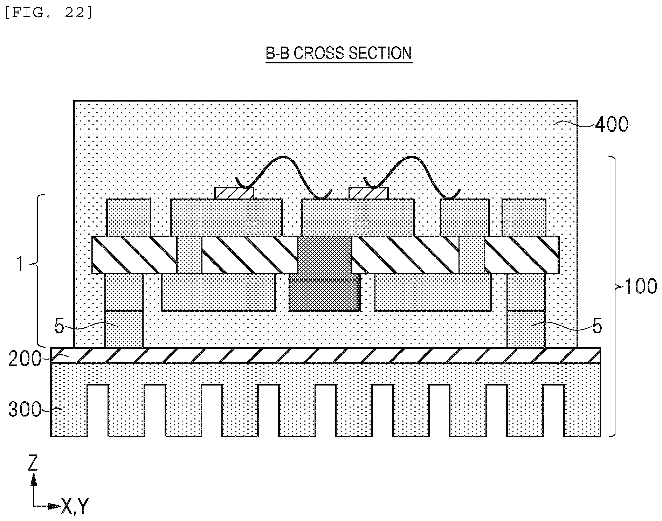

FIG. 22 shows the power conversion apparatus 100 using the insulating substrate 1 according to Embodiment 4. The heat dissipation conductors 5 are connected to the heat sink 300 via the base plate 200. In Embodiment 4, the insulating substrate 1, a plurality of semiconductor chips CHP, and the bonding wires BW are also covered with the protective member 400.

Here, since the protective member 400 is present between the protruding conductor 40 and the conductor 3b serving as a current path and between the protruding conductor 40 and the base plate 200, these members are electrically insulated. Although the protruding conductor 40 according to Embodiment 4 protrudes toward the base plate 200 to the same extent as the conductor 3b, the protruding conductor 40 only needs to protrude to such an extent that the protruding conductor 40 does not contact the base plate 200.

As described above, according to Embodiment 4, substantially the same effects as those according to Embodiment 3 can be attained, and heat dissipation can be further improved due to presence of the protruding conductor 40. Therefore, reliability of the power conversion apparatus 100 can be further improved.

### (Modification)

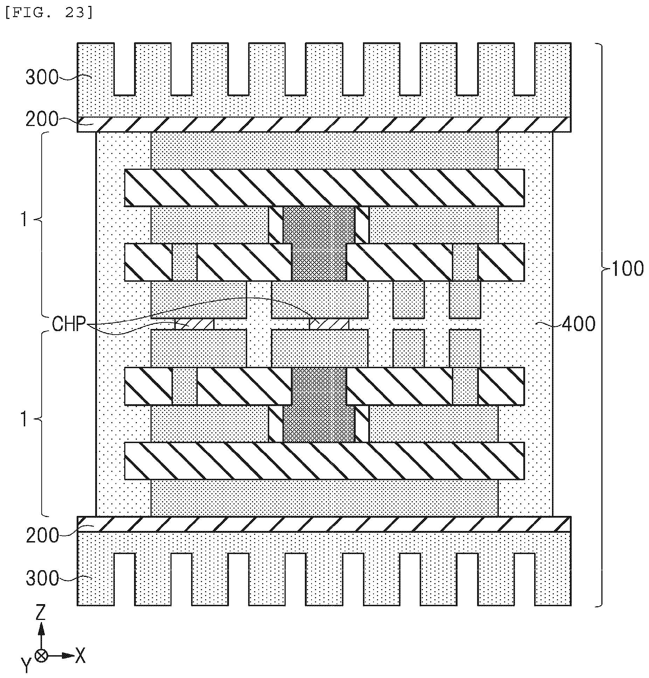

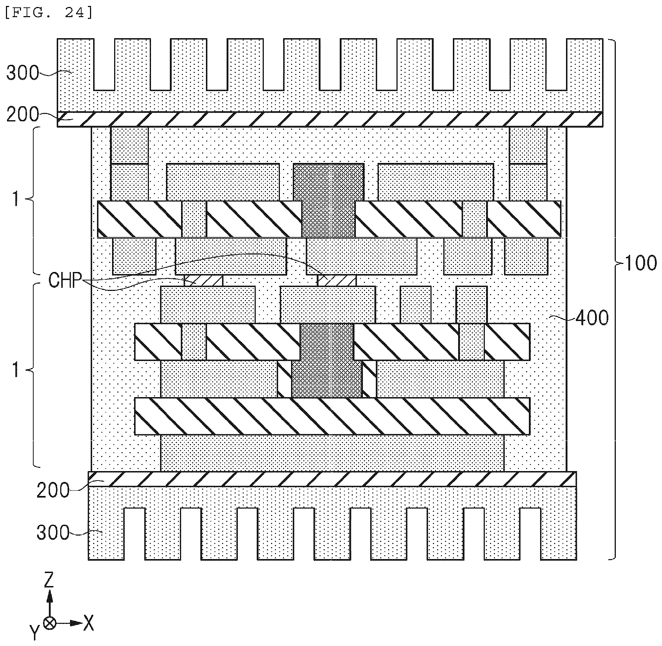

Hereinafter, the power conversion apparatus 100 according to a modification of Embodiments 1 to 4 will be described with reference to FIGS. 23 and 24.

The insulating substrate 1 is mounted only on back surfaces of the semiconductor chips CHP in the power conversion apparatus 100 according to Embodiments 1 to 4. Alternatively, the insulating substrate 1 may be mounted on top surfaces of semiconductor chips CHP as well.

As shown in FIG. 23, one insulating substrate 1 and the other insulating substrate 1 are arranged such that a plurality of conductors 3a face each other. Back surfaces of a plurality of semiconductor chips CHP are disposed on a plurality of conductors 3a of the one insulating substrate 1, and top surfaces of the plurality of semiconductor chips CHP are disposed on a plurality of conductors 3a of the other insulating substrate 1. Here, at least one of the plurality of semiconductor chips CHP is provided on the non-connected conductor 30 of the one insulating substrate 1 and on the non-connected conductor 30 of the other insulating substrate 1.

Each of the heat dissipation conductor 5 of the one insulating substrate 1 and the heat dissipation conductor 5 of the other insulating substrate 1 is connected to a respective one of the heat sinks 300 via the base plate 200. Two sets of insulating substrates 1 and the plurality of semiconductor chips CHP are covered with the protective member 400.

As described above, the parasitic inductance Ls can be reduced even in a structure in which both surfaces of each of the semiconductor chips CHP are sandwiched by the two sets of insulating substrates 1. Since heat can be dissipated from both surfaces of each of the semiconductor chips CHP, heat dissipation can be further improved. Therefore, reliability of the power conversion apparatus 100 can be improved.

The two sets of insulating substrates 1 may not have the same structure. For example, as shown in FIG. 24, a structure according to Embodiment 1 may be applied to the one insulating substrate 1, and a structure according to Embodiment 4 may be applied to the other insulating substrate 1. As described above, a combination of the two sets of insulating substrates 1 can be selected from structures according to Embodiments 1 to 4 as appropriate.

In the power conversion apparatus 100 using the two sets of insulating substrates 1, since heat can be dissipated from both surfaces of each of the semiconductor chips CHP, the base plates 200 and the heat sinks 300 may not necessarily be provided when an amount of heat dissipation is sufficient.

### Reference Signs List

1: insulating substrate
2a to 2c: insulating plate
3a to 3d: conductor
4a to 4c: connection conductor
5: heat dissipation conductor
30, 31: non-connected conductor
40: protruding conductor
41: insulating layer
100: power conversion apparatus
200: base plate
300: heat sink
400: protective member
BS1 to BS3: back surface
BW: bonding wire
CHP: semiconductor chip
TS1 to TS3: top surface

## Claims

1. An insulating substrate (1) comprising:
a first insulating plate (2a) including a top surface (TS1) and a back surface (BS1);
a second insulating plate (2b) formed on a back surface side of the first insulating plate (2a) and including a top surface (TS2) and a back surface (BS2);
a plurality of first conductors (3a) formed on the top surface (TS1) of the first insulating plate (2a);
a second conductor (3b) formed between the back surface (BS1) of the first insulating plate and the top surface (TS2) of the second insulating plate (2b);
a heat dissipation conductor (5) formed on the back surface (BS2) of the second insulating plate (2b) and electrically insulated from the second conductor (3b); and
a plurality of first connection conductors (4a) formed inside the first insulating plate (2a) in a manner of electrically connecting some of the plurality of first conductors (3a) and the second conductor (3b), wherein
the plurality of first conductors (3a) include a first non-connected conductor (30) that is not electrically connected to the second conductor (3b) via the plurality of first connection conductors (4a),
a protruding conductor (40) is formed in the first insulating plate (2a) in a manner of being embedded in the first insulating plate (2a) and protruding from the back surface (BS1) of the first insulating plate (2a), and
the protruding conductor (40) is electrically connected to the first non-connected conductor (30), and is electrically insulated from the second conductor (3b) and the heat dissipation conductor (5).

2. The insulating substrate (1) according to claim 1,
wherein
a plurality of the protruding conductors (40) are formed in the first insulating plate (2a), and
each of the plurality of protruding conductors (40) is electrically connected to the first non-connected conductor (30), and is electrically insulated from the second conductor (3b) and the heat dissipation conductor (5).

3. The insulating substrate (1) according to claim 1, further comprising:
a third insulating plate (2c) formed between the second insulating plate (2b) and the heat dissipation conductor (5) and including a top surface (TS3) and a back surface (BS3);
a third conductor (3c) formed between the back surface (BS3) of the second insulating plate (2b) and the top surface (TS3) of the third insulating plate (2c); and
a plurality of second connection conductors (4b) formed inside the second insulating plate(2b) in a manner of electrically connecting the second conductor (3b) and the third conductor (3c), wherein
the protruding conductor (40) penetrates the second insulating plate (2b), protrudes from the back surface of the second insulating plate (BS2), and is electrically insulated from the third conductor (3b) and the second connection conductors (4b), and
a structure including the third insulating plate (2c), the third conductor (3c), the plurality of second connection conductors (4b), and the protruding conductor (40) is repeatedly formed once or more from the second insulating plate (2b) to the heat dissipation conductor (5).

4. The insulating substrate (1) according to claim 1 further comprising:
a plurality of second conductors (3b) formed on the back surface (BS1) of the first insulating plate (2a); and
a plurality of first connection conductors (4a) formed inside the first insulating plate (2a) in a manner of electrically connecting some of the plurality of first conductors (3a) and some of the plurality of second conductors (3b), wherein
the plurality of second conductors (3b) include a second non-connected conductor (30) electrically insulated from another second conductor (30), and
a heat dissipation conductor (5) is connected to the second non-connected conductor in a manner of protruding from the other second conductor on a back surface side (BS1) of the first insulating plate (2a).

5. The insulating substrate (1) according to claim 4,
wherein
the plurality of second conductors (3b) include a plurality of the second non-connected conductors, and
each of the plurality of second non-connected conductors (30) is connected to the heat dissipation conductor (5).

6. The insulating substrate (1) according to claim 5,
wherein
the plurality of first conductors (3a) include a first non-connected conductor (30) that is not electrically connected to the plurality of second conductors (3b) via the plurality of first connection conductors (4a),
a protruding conductor (40) is formed in the first insulating plate (2a) in a manner of being embedded in the first insulating plate (2a) and protruding from the back surface (BS1) of the first insulating plate (2a), and
the protruding conductor (40) is electrically connected to the first non-connected conductor (30), and is electrically insulated from the plurality of second conductors (3b), the second non-connected conductor (30), and the heat dissipation conductor (5).

7. The insulating substrate (1) according to claim 6,
wherein
a plurality of the protruding conductors (40) are formed in the first insulating plate (2a), and
each of the plurality of protruding conductors (40) is electrically connected to the first non-connected conductor (30), and is electrically insulated from the plurality of second conductors (3b) and the heat dissipation conductor (5).

8. A power conversion apparatus (100) using the insulating substrate (1) according to claim 1 or 4, the power conversion apparatus comprising:
a plurality of semiconductor chips (CHP) each including a top surface and a back surface; and
a heat sink (300) connected to the heat dissipation conductor (5) via a base plate (200), wherein
back surfaces of the plurality of semiconductor chips (CHP) are disposed on the plurality of first conductors (3a).

9. The power conversion apparatus (100) according to claim 8 further comprising:
two sets of the insulating substrates (1), wherein
one insulating substrate (1) and the other insulating substrate (1) are arranged such that the plurality of first conductors (3a) face each other,
back surfaces of the plurality of semiconductor chips (CHP) are disposed on a plurality of the first conductors (3a) of the one insulating substrate (1), and
top surfaces of the plurality of semiconductor chips (CHP) are disposed on a plurality of the first conductors (3a) of the other insulating substrate (1).

10. The power conversion apparatus (100) according to claim 9, wherein
a heat sink (300) is connected to each of the heat dissipation conductor (5) of the one insulating substrate (1) and the heat dissipation conductor (5) of the other insulating substrate (1) via a base plate (200).

11. The power conversion apparatus (100) according to claim 8, wherein
each of the plurality of semiconductor chips (CHP) includes a compound semiconductor substrate and a transistor formed on the compound semiconductor substrate.

## Patentansprüche

1. Isoliersubstrat (1), umfassend:
eine erste Isolierplatte (2a) mit einer oberen Oberfläche (TS1) und einer hinteren Oberfläche (BS1);
eine zweite Isolierplatte (2b), die auf einer hinteren Oberflächenseite der ersten Isolierplatte (2a) ausgebildet ist und eine obere Oberfläche (TS2) und eine hintere Oberfläche (BS2) aufweist;
mehrere erste Leiter (3a), die auf der oberen Oberfläche (TS1) der ersten Isolierplatte (2a) ausgebildet sind;
einen zweiten Leiter (3b), der zwischen der hinteren Oberfläche (BS1) der ersten Isolierplatte und der oberen Oberfläche (TS2) der zweiten Isolierplatte (2b) ausgebildet ist;
einen Wärmeableitungsleiter (5), der auf der hinteren Oberfläche (BS2) der zweiten Isolierplatte (2b) ausgebildet und von dem zweiten Leiter (3b) elektrisch isoliert ist; und
mehrere erste Verbindungsleiter (4a), die innerhalb der ersten Isolierplatte (2a) in einer Weise ausgebildet sind, dass einige der mehreren ersten Leiter (3a) und der zweite Leiter (3b) elektrisch verbunden sind, wobei
die mehreren ersten Leiter (3a) einen ersten nicht verbundenen Leiter (30) aufweisen, der nicht mit dem zweiten Leiter (3b) über die mehreren ersten Verbindungsleiter (4a) elektrisch verbunden ist,
ein vorstehender Leiter (40) in der ersten Isolierplatte (2a) in einer Weise ausgebildet ist, dass er in die erste Isolierplatte (2a) eingebettet ist und von der hinteren Oberfläche (BS1) der ersten Isolierplatte (2a) vorsteht, und
der vorstehende Leiter (40) mit dem ersten nicht verbundenen Leiter (30) elektrisch verbunden ist und von dem zweiten Leiter (3b) und dem Wärmeableitungsleiter (5) elektrisch isoliert ist.

2. Isoliersubstrat (1) nach Anspruch 1, wobei
mehrere der vorstehenden Leiter (40) in der ersten Isolierplatte (2a) ausgebildet sind, und
jeder der mehreren vorstehenden Leiter (40) mit dem ersten nicht verbundenen Leiter (30) elektrisch verbunden ist und von dem zweiten Leiter (3b) und dem Wärmeableitungsleiter (5) elektrisch isoliert ist.

3. Isoliersubstrat (1) nach Anspruch 1, ferner umfassend:
eine dritte Isolierplatte (2c), die zwischen der zweiten Isolierplatte (2b) und dem Wärmeableitungsleiter (5) ausgebildet ist und eine obere Oberfläche (TS3) und eine hintere Oberfläche (BS3) aufweist;
einen dritten Leiter (3c), der zwischen der hinteren Oberfläche (BS3) der zweiten Isolierplatte (2b) und der oberen Oberfläche (TS3) der dritten Isolierplatte (2c) ausgebildet ist; und
mehrere zweite Verbindungsleiter (4b), die innerhalb der zweiten Isolierplatte (2b) in einer Weise ausgebildet sind, dass der zweite Leiter (3b) und der dritte Leiter (3c) elektrisch verbunden sind, wobei
der vorstehende Leiter (40) die zweite Isolierplatte (2b) durchdringt, von der hinteren Oberfläche der zweiten Isolierplatte (BS2) vorsteht und von dem dritten Leiter (3b) und den zweiten Verbindungsleitern (4b) elektrisch isoliert ist, und
eine Struktur, die die dritte Isolierplatte (2c), den dritten Leiter (3c), die mehreren zweiten Verbindungsleiter (4b) und den vorstehenden Leiter (40) aufweist, wiederholt einmal oder mehrmals von der zweiten Isolierplatte (2b) zu dem Wärmeableitungsleiter (5) ausgebildet ist.

4. Isoliersubstrat (1) nach Anspruch 1, ferner umfassend:
mehrere zweite Leiter (3b), die auf der hinteren Oberfläche (BS1) der ersten Isolierplatte (2a) ausgebildet sind; und
mehrere erste Verbindungsleiter (4a), die innerhalb der ersten Isolierplatte (2a) in einer Weise ausgebildet sind, dass einige der mehreren ersten Leiter (3a) und einige der mehreren zweiten Leiter (3b) elektrisch verbunden sind, wobei
die mehreren zweiten Leiter (3b) einen zweiten nicht verbundenen Leiter (30) aufweisen, der von einem anderen zweiten Leiter (30) elektrisch isoliert ist, und
ein Wärmeableitungsleiter (5) mit dem zweiten nicht verbundenen Leiter in einer Weise verbunden ist, dass er von dem anderen zweiten Leiter auf einer hinteren Oberflächenseite (BS1) der ersten Isolierplatte (2a) vorsteht.

5. Isoliersubstrat (1) nach Anspruch 4, wobei
die mehreren zweiten Leiter (3b) mehrere der zweiten nicht verbundenen Leiter aufweisen, und
jeder der mehreren zweiten nicht verbundenen Leiter (30) mit dem Wärmeableitungsleiter (5) verbunden ist.

6. Isoliersubstrat (1) nach Anspruch 5, wobei
die mehreren ersten Leiter (3a) einen ersten nicht verbundenen Leiter (30) aufweisen, der nicht mit den mehreren zweiten Leitern (3b) über die mehreren ersten Verbindungsleiter (4a) elektrisch verbunden ist,
ein vorstehender Leiter (40) in der ersten Isolierplatte (2a) in einer Weise ausgebildet ist, dass er in die erste Isolierplatte (2a) eingebettet ist und von der hinteren Oberfläche (BS1) der ersten Isolierplatte (2a) vorsteht, und
der vorstehende Leiter (40) mit dem ersten nicht verbundenen Leiter (30) elektrisch verbunden ist und von den mehreren zweiten Leitern (3b), dem zweiten nicht verbundenen Leiter (30) und dem Wärmeableitungsleiter (5) elektrisch isoliert ist.

7. Isoliersubstrat (1) nach Anspruch 6, wobei
mehrere der vorstehenden Leiter (40) in der ersten Isolierplatte (2a) ausgebildet sind, und
jeder der mehreren vorstehenden Leiter (40) mit dem ersten nicht verbundenen Leiter (30) elektrisch verbunden ist und von den mehreren zweiten Leitern (3b) und dem Wärmeableitungsleiter (5) elektrisch isoliert ist.

8. Leistungsumwandlungsvorrichtung (100), die das Isoliersubstrat (1) nach Anspruch 1 oder 4 verwendet, wobei die Leistungsumwandlungsvorrichtung umfasst:
mehrere Halbleiterchips (CHP), die jeweils eine obere Oberfläche und eine hintere Oberfläche aufweisen; und
eine Wärmesenke (300), die über eine Grundplatte (200) mit dem Wärmeableitungsleiter (5) verbunden ist, wobei
hintere Oberflächen der mehreren Halbleiterchips (CHP) auf den mehreren ersten Leitern (3a) angeordnet sind.

9. Leistungsumwandlungsvorrichtung (100) nach Anspruch 8, ferner umfassend:
zwei Sätze der Isoliersubstrate (1), wobei
ein Isoliersubstrat (1) und das andere Isoliersubstrat (1) so angeordnet sind, dass die mehreren ersten Leiter (3a) einander zugewandt sind,
hintere Oberflächen der mehreren Halbleiterchips (CHP) auf mehreren der ersten Leiter (3a) des einen Isoliersubstrats (1) angeordnet sind, und
obere Oberflächen der mehreren Halbleiterchips (CHP) auf mehreren der ersten Leiter (3a) des anderen Isoliersubstrats (1) angeordnet sind.

10. Leistungsumwandlungsvorrichtung (100) nach Anspruch 9, wobei
eine Wärmesenke (300) über eine Grundplatte (200) mit jedem des Wärmeableitungsleiters (5) des einen Isoliersubstrats (1) und des Wärmeableitungsleiters (5) des anderen Isoliersubstrats (1) verbunden ist.

11. Leistungsumwandlungsvorrichtung (100) nach Anspruch 8, wobei
jeder der mehreren Halbleiterchips (CHP) ein Verbundhalbleitersubstrat und einen auf dem Verbundhalbleitersubstrat ausgebildeten Transistor aufweist.

## Revendications

1. Substrat isolant (1) comprenant :
une première plaque isolante (2a) comprenant une surface supérieure (TS1) et une surface arrière (BS1) ;
une seconde plaque isolante (2b) formée sur un côté de surface arrière de la première plaque isolante (2a) et comprenant une surface supérieure (TS2) et une surface arrière (BS2) ;
une pluralité de premiers conducteurs (3a) formés sur la surface supérieure (TS1) de la première plaque isolante (2a) ;
un second conducteur (3b) formé entre la surface arrière (BS1) de la première plaque isolante et la surface supérieure (TS2) de la seconde plaque isolante (2b) ;
un conducteur de dissipation de chaleur (5) formé sur la surface arrière (BS2) de la seconde plaque isolante (2b) et isolé électriquement du second conducteur (3b) ; et
une pluralité de premiers conducteurs de connexion (4a) formés à l'intérieur de la première plaque isolante (2a) de manière à connecter électriquement certains de la pluralité de premiers conducteurs (3a) et le second conducteur (3b), dans lequel
la pluralité de premiers conducteurs (3a) comprennent un premier conducteur non connecté (30) qui n'est pas connecté électriquement au second conducteur (3b) via la pluralité de premiers conducteurs de connexion (4a),
un conducteur en saillie (40) est formé dans la première plaque isolante (2a) de manière à être noyé dans la première plaque isolante (2a) et faisant saillie de la surface arrière (BS1) de la première plaque isolante (2a), et
le conducteur en saillie (40) est connecté électriquement au premier conducteur non connecté (30), et est isolé électriquement du second conducteur (3b) et du conducteur de dissipation de chaleur (5).

2. Substrat isolant (1) selon la revendication 1, dans lequel
une pluralité des conducteurs en saillie (40) sont formés dans la première plaque isolante (2a), et
chacun de la pluralité de conducteurs en saillie (40) est connecté électriquement au premier conducteur non connecté (30), et est isolé électriquement du second conducteur (3b) et du conducteur de dissipation de chaleur (5).

3. Substrat isolant (1) selon la revendication 1, comprenant en outre :
une troisième plaque isolante (2c) formée entre la seconde plaque isolante (2b) et le conducteur de dissipation de chaleur (5) et comprenant une surface supérieure (TS3) et une surface arrière (BS3) ;
un troisième conducteur (3c) formé entre la surface arrière (BS3) de la seconde plaque isolante (2b) et la surface supérieure (TS3) de la troisième plaque isolante (2c) ; et
une pluralité de seconds conducteurs de connexion (4b) formés à l'intérieur de la seconde plaque isolante (2b) de manière à connecter électriquement le second conducteur (3b) et le troisième conducteur (3c), dans lequel
le conducteur en saillie (40) pénètre dans la seconde plaque isolante (2b), fait saillie de la surface arrière de la seconde plaque isolante (BS2), et est isolé électriquement du troisième conducteur (3b) et des seconds conducteurs de connexion (4b), et
une structure comprenant la troisième plaque isolante (2c), le troisième conducteur (3c), la pluralité de seconds conducteurs de connexion (4b), et le conducteur en saillie (40) est formée de manière répétée une fois ou plus de la seconde plaque isolante (2b) au conducteur de dissipation de chaleur (5).

4. Substrat isolant (1) selon la revendication 1, comprenant en outre :
une pluralité de seconds conducteurs (3b) formés sur la surface arrière (BS1) de la première plaque isolante (2a) ; et
une pluralité de premiers conducteurs de connexion (4a) formés à l'intérieur de la première plaque isolante (2a) de manière à connecter électriquement certains de la pluralité de premiers conducteurs (3a) et certains de la pluralité de seconds conducteurs (3b), dans lequel
la pluralité de seconds conducteurs (3b) comprennent un second conducteur non connecté (30) isolé électriquement d'un autre second conducteur (30), et
un conducteur de dissipation de chaleur (5) est connecté au second conducteur non connecté de manière à faire saillie de l'autre second conducteur sur un côté de surface arrière (BS1) de la première plaque isolante (2a).

5. Substratisolant (1) selon la revendication 4, dans lequel
la pluralité de seconds conducteurs (3b) comprennent une pluralité des seconds conducteurs non connectés, et
chacun de la pluralité de seconds conducteurs non connectés (30) est connecté au conducteur de dissipation de chaleur (5).

6. Substrat isolant (1) selon la revendication 5, dans lequel
la pluralité de premiers conducteurs (3a) comprennent un premier conducteur non connecté (30) qui n'est pas connecté électriquement à la pluralité de seconds conducteurs (3b) via la pluralité de premiers conducteurs de connexion (4a),
un conducteur en saillie (40) est formé dans la première plaque isolante (2a) de manière à être noyé dans la première plaque isolante (2a) et faisant saillie de la surface arrière (BS1) de la première plaque isolante (2a), et
le conducteur en saillie (40) est connecté électriquement au premier conducteur non connecté (30), et est isolé électriquement de la pluralité de seconds conducteurs (3b), du second conducteur non connecté (30), et du conducteur de dissipation de chaleur (5).

7. Substrat isolant (1) selon la revendication 6, dans lequel
une pluralité des conducteurs en saillie (40) sont formés dans la première plaque isolante (2a), et
chacun de la pluralité de conducteurs en saillie (40) est connecté électriquement au premier conducteur non connecté (30), et est isolé électriquement de la pluralité de seconds conducteurs (3b) et du conducteur de dissipation de chaleur (5).

8. Appareil de conversion de puissance (100) utilisant le substrat isolant (1) selon la revendication 1 ou 4, l'appareil de conversion de puissance comprenant :
une pluralité de puces semi-conductrices (CHP) comprenant chacune une surface supérieure et une surface arrière ; et
un dissipateur de chaleur (300) connecté au conducteur de dissipation de chaleur (5) par l'intermédiaire d'une plaque de base (200), dans lequel
les surfaces arrière de la pluralité de puces semi-conductrices (CHP) sont disposées sur la pluralité de premiers conducteurs (3a).

9. Appareil de conversion de puissance (100) selon la revendication 8, comprenant en outre :
deux ensembles des substrats isolants (1), dans lequel
un substrat isolant (1) et l'autre substrat isolant (1) sont agencés de sorte que la pluralité de premiers conducteurs (3a) se font face,
les surfaces arrière de la pluralité de puces semi-conductrices (CHP) sont disposées sur une pluralité des premiers conducteurs (3a) du premier substrat isolant (1), et
les surfaces supérieures de la pluralité de puces semi-conductrices (CHP) sont disposées sur une pluralité des premiers conducteurs (3a) de l'autre substrat isolant (1).

10. Appareil de conversion de puissance (100) selon la revendication 9, dans lequel
un dissipateur de chaleur (300) est connecté à chacun du conducteur de dissipation de chaleur (5) du premier substrat isolant (1) et du conducteur de dissipation de chaleur (5) de l'autre substrat isolant (1) par l'intermédiaire d'une plaque de base (200).

11. Appareil de conversion de puissance (100) selon la revendication 8, dans lequel
chacune de la pluralité de puces semi-conductrices (CHP) comprend un substrat semi-conducteur composé et un transistor formé sur le substrat semi-conducteur composé.
